# EUROPÄISCHE PATENTSCHRIFT

(11) **EP 2 729 823 B1**
(45) Veröffentlichungstag und Bekanntmachung des Hinweises auf die Patenterteilung: **28.10.2015**
(21) Anmeldenummer: 12759024.8
(22) Anmeldetag: 08.08.2012
(51) Int. Cl.: G01R 33/18, G01R 33/028

(54) **MESSKOPF FÜR EINEN MAGNETOELASTISCHEN SENSOR**
MEASUREMENT HEAD FOR A MAGNETOELASTIC SENSOR
TÊTE DE MESURE POUR CAPTEUR MAGNÉTOÉLASTIQUE

(30) Priorität: 31.08.2011 DE 102011081869
(43) Veröffentlichungstag der Anmeldung: 14.05.2014
(73) Patentinhaber: Siemens Aktiengesellschaft, 80333 München (DE)
(72) Erfinder: MAIER, Carl, Udo, 70499 Stuttgart (DE); OSTERMAIER, Jochen, 91056 Erlangen (DE)
(86) Internationale Anmeldenummer: PCT/EP2012/065536
(87) Internationale Veröffentlichungsnummer: WO 2013/029949

(56) Entgegenhaltungen:
- DE-U1- 9 304 629
- US-A- 4 566 338

## Beschreibung

Die vorliegende Erfindung betrifft einen Messkopf für einen magnetoelastischen Sensor sowie einen magnetoelastischen Sensor mit einem derartigen Messkopf.

Ein magnetoelastischer Sensor beruht auf dem inversen magnetostriktiven Effekt, also dem Effekt, dass ferromagnetische Materialien eine Änderung in der magnetischen Permeabilität erfahren, wenn mechanische Spannungen auftreten. Da mechanische Spannungen durch Zug- und Druckkräfte sowie durch Torsion induziert werden, kann der inverse magnetostriktive Effekt zur Kraft- und zur Drehmomentmessung herangezogen werden und ist daher vielseitig einsetzbar.

Messköpfe zum Messen des inversen magnetostriktiven Effekts umfassen eine Sende- oder Erregerspule, mit der in der ferromagnetischen Schicht ein Magnetfeld induziert wird. Dabei wird in der Schicht ein Antwortsignal generiert, dessen magnetische Flussdichte von der Permeabilität der Schicht abhängt. Diese wird wiederum von den in der Schicht herrschenden mechanischen Spannungen bestimmt. Die magnetische Flussdichte des Antwortsignals bestimmt die Stromstärke des in der Empfangsspule auf Grund der sie durchsetzenden magnetischen Flussdichte induzierten Stroms. Aus der Stromstärke können dann die mechanischen Spannungen in der ferromagnetischen Schicht errechnet werden.

Die US 4,566,338 beschreibt einen kontaktfreien Drehmomentsensor, der als magnetoelastischer Sensor ausgebildet ist. Der Sensor umfasst fünf Pole, wobei eine Erregerspule auf einem zentralen Pol angebracht ist. Auf den übrigen Polen sind Empfängerspulen angebracht. Die Pole sind über ein Joch miteinander verbunden, wobei die Empfängerspulen an dem an das Joch angrenzenden Ende der Pole angeordnet sind. Aufgrund von Fertigungstoleranzen haben die Empfangsspulen - und damit die Messköpfe - jedoch eine begrenzte Reproduzierbarkeit in der Herstellung und eine begrenzte Genauigkeit bei der Messung.

Die DE 93 04 629.4 U1 beschreibt einen Drehmomentsensor, der Magnetfeldsensoren aufweist, die auf dem Hall-Effekt beruhen, und der auf einem Siliziumwafer realisiert werden kann. Auf dem Halbleitermaterial des Sensors ist eine galvanische NiFe-Schicht als Joch aufgebracht.

Aufgabe der vorliegenden Erfindung ist es daher, einen Messkopf für einen magnetoelastischen Sensor zur Verfügung zustellen, der eine höhere Reproduzierbarkeit in der Herstellung und eine verbesserte Genauigkeit bei der Messung ermöglicht. Eine weitere Aufgabe der Erfindung ist es, einen vorteilhaften magnetoelastischen Sensor zur Verfügung zu stellen.

Die erste Aufgabe wird durch einen Messkopf nach Anspruch 1 gelöst, die zweite Aufgabe durch einen magnetoelastischen Sensor nach Anspruch 12. Die abhängigen Ansprüche enthalten vorteilhafte Ausgestaltungen der Erfindung.

Ein erfindungsgemäßer Messkopf für einen magnetoelastischen Sensor umfasst einen Ferritkern mit einem ersten Ende, auf dem eine ein Magnetfeld erzeugende Erregerspule (auch Sendespule genannt) aufgebracht ist, und mit wengistens einem zweiten Ende, auf dem ein Magnetfeldsensor angebracht ist. Als Magnetfeldsensor kommt hierbei insbesondere ein auf dem Hall-Effekt beruhender Magnetfeldsensor, ein auf dem GMR-Effekt (englisch: Giant magneto resistance, zu Deutsch: Riesenmagnetowiederstand) beruhender Magnetfeldsensor oder ein auf dem AMR-Effekt (Anisotopa magnetoresistiva Effekt) beruhender Magnetfeldsensor in Betracht.

Durch die Verwendung eines Magnetfeldsensors statt einer einfachen Empfangsspule zum Detektieren des durch die Erregerspule in einer ferromagnetischen Schicht induzierten Antwortsignals kann die Empfindlichkeit des Messkopfes verbessert werden. Außerdem sind die Magnetfeldsensoren mit geringeren Fertigungstoleranzen herstellbar als die schwierig herzustellenden Empfangsspulen. Damit kann der erfindungsgemäße Messkopf einfacher und kostengünstiger hergestellt werden. Außerdem vermindert sich die Variabilität der hergestellten Messköpfe aufgrund der verminderten Toleranzen.

Der Ferritkern, auf dem die Sendespule und der Magnetfeldsensor angeordnet sind, kann insbesondere eine U-Form aufweisen. Die U-Form weist zwei Schenkel auf, welche die Enden des Ferritkerns umfassen. Dabei ist die Erregerspule auf dem einen Schenkel des U-förmigen Ferritkerns und der Magnetfeldsensor auf dem anderen Schenkel auf dem U-förmigen Ferritkerns angeordnet.

Alternativ kann der Ferritkern einen mittleren Schenkel und wenigstens zwei den mittleren Schenkel umgebende und mit diesem verbundene äußere Schenkel aufweisen, wobei sich die Enden des Ferritkerns an den Schenkeln befinden. Die Erregerspule ist in dieser Ausgestaltung auf dem mittleren Schenkel des Ferritkerns angeordnet, die Magnetfeldsensoren auf den äußeren Schenkeln des Ferritkerns. Hierbei ist es insbesondere vorteilhaft, wenn die äußeren Schenkel den mittleren Schenkel in jeweils gleichem Abstand umgeben, da dann die von den Magnetfeldsensoren empfangenen Signale nicht durch unterschiedliche Abstände der jeweiligen Schenkel von der Erregerspule beeinflusst werden.

Im Falle von zwei äußeren Schenkeln kann der Ferritkern insbesondere einen E-Form aufweisen. Dadurch kann die Strecke durch das zu messende ferromagnetische Material im Vergleich zur U-Form vergrößert werden, woraus eine verbesserte Empfindlichkeit des Messkopfes resultiert. In dieser Ausgestaltung liegen die Magnetfeldsensoren einander in Bezug auf die Erregerspule vorzugsweise spiegelsymmetisch gegenüber, um Einflüsse auf die Messung, die ausschließlich auf den unterschiedlichen Abständen zu Erregerspule beruhen, auszuschließen.

Wenn der Ferritkern mehr als zwei äußere Schenkel aufweist, können die Magnetfeldsensoren insbesondere punktsymmetrisch oder rotationssymmetrisch um den Ferritkern herum angeordnet sein. Insbesondere beim Vorhandensein von vier äußeren Schenkeln können so Spannungen, die in zueinander senkrechten Richtungen in der ferromagnetischen Schicht verlaufen, gut erfasst werden. Solche Messköpfe können besonders vorteilhaft zum Messen von Torsion und Drehmomenten, beispielsweise in Wellen, zum Einsatz kommen.

Gemäß einem zweiten Aspekt der Erfindung wird ein magnetoelastischer Sensor zur Verfügung gestellt. Dieser weist einen erfindungsgemäßen Messkopf auf, so dass in ihm die mit Bezug auf den Messkopf beschriebenen Eigenschaften und Vorteile realisiert sind.

Weitere Merkmale, Eigenschaften und Vorteile der vorliegenden Erfindung ergeben sich aus der nachfolgenden Beschreibung von Ausführungsbeispielen unter Bezugnahme auf die beiliegenden Figuren.
Figur 1 zeigt ein Ausführungsbeispiel für einen erfindungsgemäßen magnetoelastischen Sensor mit einem U-förmigen Messkopf.
Figur 2 zeigt ein Ausführungsbeispiel für einen erfindungsgemäßen magnetoelastischen Sensor mit einem E-förmigen Messkopf.
Figur 3 zeigt ein weiteres Ausführungsbeispiel für einen erfindungsgemäßen magnetoelastischen Sensor in einer Seitenansicht.
Figur 4 zeigt den Messkopf des Sensors aus Figur 3 in einer Draufsicht.

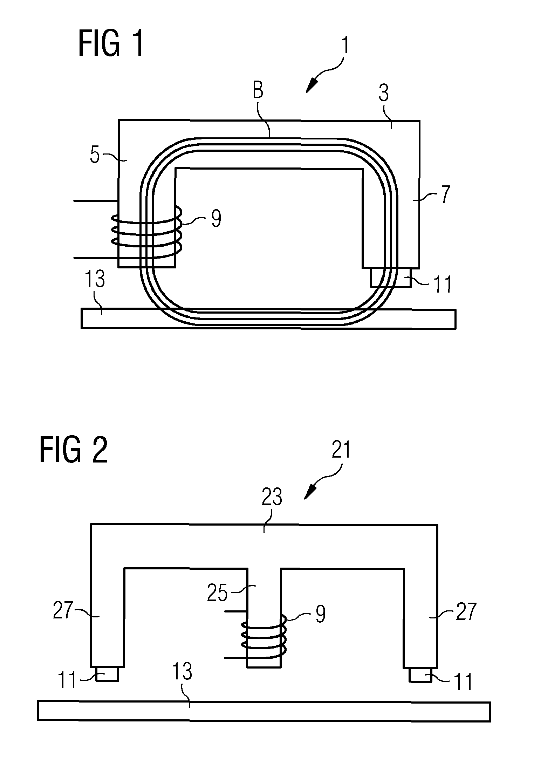

Ein erstes Ausführungsbeispiel für einen erfindungsgemäßen Messkopf und einen damit ausgestatteten magnetoelastischen Sensor ist in Figur 1 dargestellt. Der Messkopf 1 umfasst einen U-förmigen Ferritkern 3, welcher zwei parallel zueinander ausgerichtete Schenkel 5 und 7 aufweist. Auf den ersten Schenkel 5 ist eine Erregerspule 9 aufgebracht, mit der ein Magnetfeld generiert werden kann. Auf dem zweiten Schenkel 7 ist ein Magnetfeldsensor 11 angeordnet, der im vorliegenden Ausführungsbeispiel als Hall-Sensor ausgebildet ist.

Zusammen mit einer ferromagnetischen Schicht 13, die auf einem Objekt angeordnet ist, in dem Spannungen gemessen werden sollen, bildet der Messkopf 1 einen magnetoelastischen Sensor. Die Schicht 13 kann dabei auf dem zu messenden Objekt aufgebracht sein. Alternativ kann das zu messende Objekt selbst aber auch aus einen ferromagnetischen Material bestehen. In diesem Fall wird der magnetoelastische Sensor vom Objekt selbst zusammen mit dem Messkopf 1 gebildet.

Für den Messvorgang des Sensors wird mittels der Erregerspule 9 ein Magnetfeld erzeugt, dessen magnetische Flussdichte in Figur 1 durch die Feldlinien B dargestellt ist. Die Feldlinien verlaufen durch die ferromagnetische Schicht 13 und werden über den Ferritkern 3 geschlossen. Mittels des Magnetfeldsensors (hier Hall-Sensor) 11 kann die magnetische Flussdichte des Magnetfeldes gemessen werden. Der Messwert hängt dabei von der magnetischen Permeabilität in der ferromagnetischen Schicht 13 ab, die wiederum von den in der ferromagnetischen Schicht herrschenden Spannungen beeinflusst wird. Aus dem mit dem Magnetfeldsensor 11 gewonnenen Messergebnis für die magnetische Flussdichte können daher die in der ferromagnetischen Schicht 13 herrschenden Spannungen berechnet werden. Da die ferromagnetische Schicht 13 entweder das Objekt selber darstellt oder mit dem Objekt verbunden ist, repräsentieren die in der ferromagnetischen Schicht 13 herrschenden Spannungen auch die im Messobjekt herrschenden Spannungen.

Ein zweites Ausführungsbeispiel für einen erfindungsgemäßen Messkopf und einen den Messkopf umfassenden magnetoelastischen Sensor ist in Figur 2 dargestellt. Elemente, die denen des ersten Ausführungsbeispiels entsprechen, sind mit denselben Bezugsziffern wie in Figur 1 gekennzeichnet und werden nicht noch einmal erläutert, um Wiederholungen zu vermeiden. Die Erläutung des zweiten Ausführungsbeispiels beschränkt sich daher auf die Unterschiede zum ersten Ausführungsbeispiel.

Im Unterschied zum ersten Ausführungsbeispiel weist der Messkopf 21 des zweiten Ausführungsbeispiels einen E-förmigen Ferritkern 23 auf. Dieser umfasst einen mittleren Schenkel 25 und zwei äußere Schenkel 27, die auf einer Achse mit dem mittleren Schenkel 25 angeordnet sind. Alle Schenkel sind vorzugsweise parallel zueinander ausgerichtet. Die äußeren Schenkel 27 weisen beide denselben Abstand von mittleren Schenkel 25 auf, so dass eine in Bezug auf den mittleren Schenkel 25 spiegelsymmetrische Geometrie des Ferritkerns 23 vorliegt.

Die Erregerspule 9 des Messkopfes 21 ist auf dem mittleren Schenkel des Ferritkerns 23 angeordnet. Auf den beiden äußeren Schenkeln 27 des Ferritkerns 23 befinden sich die Magnetfeldsensoren 11, die wie im ersten Ausführungsbeispiel als Hall-Sensoren ausgebildet sind. Die magnetische Flussdichte des von der Erregerspule 9 generierten Magnetfeldes wird in dieser Ausführungsvariante an zwei Stellen gemessen, die bezogen auf die Erregerspule 9 einander spiegelsymmetrisch gegenüberliegen.

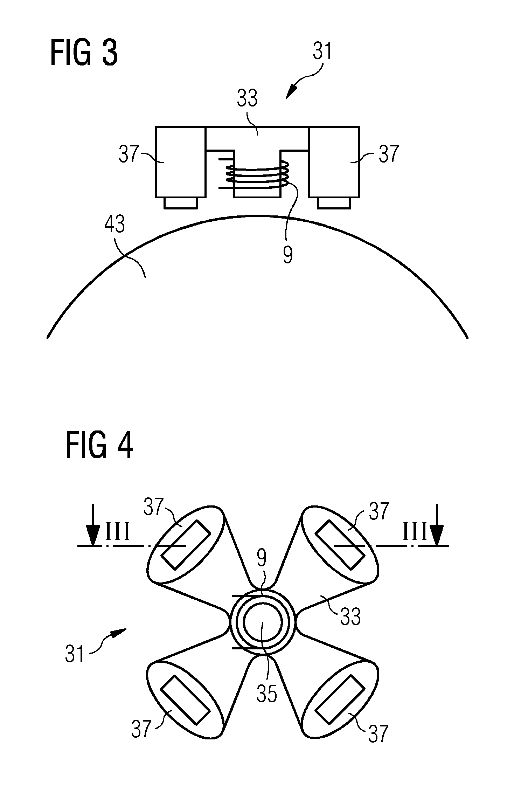

Ein drittes Ausführungsbeispiel für einen erfindungsgemäßen Messkopf und einen damit aufgebauten magnetoelastischen Torsionssensor ist in den Figuren 3 und 4 dargestellt. Figur 3 zeigt dabei eine Seitenansicht durch den Messkopf entlang der Linie III-III in Figur 4. Figur 4 zeigt eine Draufsicht auf die dem ferromagnetischen Material zuzuwendende Seite des Messkopfes.

Der Messkopf 31 des dritten Ausführungsbeispiels weist einen Ferritkern 33 mit einem mittleren Schenkel 35 und vier den mittleren Schenkel 35 umgebenden äußeren Schenkeln 37 auf. Auf dem mittleren Schenkel 35 ist die Erregerspule 9 angeordnet. Die Magnetfeldsensoren 41, die im vorliegenden Ausführungszeichen als GMR-Sensoren oder AMR-Sensoren ausgebildet sind, befinden sich auf den äußeren Schenkeln 37. Die Geometrie des Ferritkerns 31 ist im vorliegenden Ausführungsbeispiel so gewählt, dass die Schenkel zwei Schenkelpaare bilden, in denen jeweils zwei Schenkel einander auf entgegengesetzten Seiten des mittleren Schenkels 35 gegenüber liegen. Die beiden Schenkelpaare weisen eine um 90° gegeneinander verdrehte Orientierung auf, so dass eine Punktsymmetrie in der Anordnung der äußeren Schenkel 37 in Bezug auf den mittleren Schenkel 35 vorliegt. Diese Ausgestaltung des Messkopfes 31 ermöglicht eine zweidimensionale Erfassung von Kräften, wie dies bspw. zum Messen von Torsionen in einer Welle 43 oder von Drehmomenten einer Welle vorteilhaft ist. Die Welle 43 kann dabei entweder aus einem ferromagnetischen Material bestehen oder mit einem solchen beschichtet sein.

Für das Bestimmen der Torsion an der Welle 43 wird der Sensorkopf mit den Verbindungslinie zwischen einander gegenüberliegenden äußeren Schenkeln 37 eines Schenkelpaares entlang der bei der Torsion auftretenden Hauptkräfte ausgerichtet, die senkrecht zueinander verlaufen. Bei einer Torsion herrschen in einer Richtung eine Zugkraft und in die dazu senkrechte Richtung eine Druckkraft vor. Dies bedeutet, dass die magnetische Permeabilität des ferromagnetischen Materials der Welle 43 in die eine Richtung größer und in die andere Richtung kleiner wird. Mittels der in Figur 3 und Figur 4 dargestellten Geometrie des Sensorkopfes 31 können die Permeabilitäten in die beiden Richtungen getrennt voneinander erfasst werden, so dass sich die Torsion der Welle aus den erfassten Permeabilitäten und den daraus zu errechnenden Zug bzw. Druck Spannungen ermitteln lässt.

Die vorliegende Erfindung wurde anhand von exemplarischen Ausführungsbeispielen zu Illustrationszwecken beschrieben. Die Ausführungsbeispiele sollen jedoch die Erfindung nicht einschränken, so dass der Schutzumfang lediglich durch die beigefügten Ansprüche beschränkt ist. Insbesondere sich Abweichungen von den dargestellten Ausführungsbeispielen möglich. So kann beispielsweise in den ersten beiden Ausführungsbeispielen statt des verwendeten Hall-Sensors auch ein anderer Magnetfeldsensor, beispielsweise ein GMR-Sensor oder AMR-Sensor, Verwendung finden.

Die mit Bezug auf das zweite Ausführungsbeispiel und das dritte Ausführungsbeispiel beschriebenen Symmetrien sind vorteilhaft aber nicht unbedingt notwendig, da die bei einer nicht symmetrischen Anordnung auftretenden Beeinflussungen der Messsignale grundsätzlich bei der Verarbeitung der Messsignale berücksichtigt werden können. In einer nicht symmetrischen Geometrie des E-förmigen Ferritkerns können bspw. die äußeren Schenkel unterschiedliche Abstände vom mittleren Schenkel aufweisen. Außerdem brauchen die äußeren Schenkel und der mittlere Schenkel nicht notwendiger Weise auf einer Linie angeordnet zu sein. Entsprechend ist es bei dem Messkopf des dritten Ausführungsbeispiels nicht notwendig, dass die Positionen der äußeren Schenkel des Ferritkerns eine Punktsymmetrie bezogen auf den mittleren Schenkel aufweisen. Außerdem ist es auch nicht notwendig, dass vier Schenkel vorliegen. Drei Schenkel sind grundsätzlich ausreichend, um zweidimensionale Kräfte zu erfassen. Diese können dann bspw. an den Ecken eines Polygons mit dem mittleren Schenkel als Zentrum angeordnet sein. Gleiches gilt auch unabhängig von der Anzahl der vorhandenen äußeren Schenkel. Aber auch eine völlig symmetrielose Anordnung der äußeren Schenkel ist grundsätzlich möglich. Jedoch ist das Auswerten der Signale eines mit vier symmetrisch angeordneten Schenkeln ausgestatteten Messkopfes einfacher, insbesondere wenn dieser die in den Figuren 3 und 4 gezeigte Geometrie aufweist.

Als eine weitere Abwandlung der gezeigten Ausführungsbeispiele besteht die Möglichkeit, einen Magnetfeldsensor auch auf dem Schenkel anzuordnen, der die Erregerspule trägt.

## Patentansprüche

1. Messkopf (1, 21, 31) für einen magnetoelastischen Sensor mit einem Ferritkern (3, 23, 33), der eine U-Form mit zwei Schenkeln aufweist und der ein erstes Ende (5), auf dem eine ein Magnetfeld erzeugende Erregerspule (9) aufgebracht ist, und wenigstens ein zweites Ende (7) umfasst, wobei auf dem wenigstens einen zweiten Ende (7) ein Magnetfeldsensor (11, 41) angebracht ist, **gekennzeichnet dadurch, dass** der Magnetfeldsensor auf dem Hall-, GMR-, oder AMR-Effekt beruht.

2. Messkopf (21, 31) nach Anspruch 1 in dem der Ferritkern (23, 33) einen zusätzlichen Schenkel (25, 35) aufweist, wobei die Erregerspule (9) auf dem zusätzlichen Schenkel (25, 35) des Ferritkerns (23, 33) angeordnet ist und Magnetfeldsensoren (11, 41) auf den äußeren Schenkeln (27, 37) des Ferritkerns (23, 33) angeordnet sind.

3. Messkopf (21, 31) nach Anspruch 2 in dem die äußeren Schenkel (27, 37) den zusätzlichen Schenkel (25, 35) in jeweils gleichem Abstand umgeben.

4. Messkopf (21) nach Anspruch 2 oder Anspruch 3, in dem der Ferritkern (23) eine E-Form mit einem zusätzlichen Schenkel (25) und zwei äußeren Schenkeln (27) aufweist.

5. Messkopf (21) nach Anspruch 4, in dem die äußeren Schenkel (27) bezogen auf den zusätzlichen Schenkel (25) einander spiegelsymmetrisch gegenüber liegen.

6. Messkopf (31) nach Anspruch 2 oder Anspruch 3, in dem der Ferritkern einen zusätzlichen Schenkel (35) und wenigstens drei äußere Schenkel (37) aufweist.

7. Messkopf (31) nach Anspruch 6 in dem die wenigstens drei äußeren Schenkel (37) punktsymmetrisch oder rotationssymmetrisch um den zusätzlichen Schenkel (35) herum angeordnet sind.

8. Magnetoelastischer Sensor mit einem Messkopf nach einem der vorangehenden Ansprüche.

## Claims

1. Measurement head (1, 21, 31) for a magnetoelastic sensor having a ferrite core (3, 23, 33) which has a U shape with two limbs and which comprises a first end (5) on which an exciter coil (9) which generates a magnetic field is mounted, and at least one second end (7), wherein a magnetic field sensor (11, 41) is attached to the at least one second end (7), **characterized in that** the magnetic field sensor is based on the Hall effect, GMR effect or AMR effect.

2. Measurement head (21, 31) according to Claim 1, in which the ferrite core (23, 33) has an additional limb (25, 35), wherein the exciter coil (9) is arranged on the additional limb (25, 35) of the ferrite core (23, 33), and magnetic field sensors (11, 41) are arranged on the outer limbs (27, 37) of the ferrite core (23, 33).

3. Measurement head (21, 31) according to Claim 2, in which the outer limbs (27, 37) surround the additional limb (25, 35) at a respective equal distance.

4. Measurement head (21) according to Claim 2 or Claim 3, in which the ferrite core (23) has an E shape with an additional limb (25) and two outer limbs (27).

5. Measurement head (21) according to Claim 4, in which the outer limbs (27) are located opposite one another in a mirror symmetrical fashion with respect to the additional limb (25).

6. Measurement head (31) according to Claim 2 or Claim 3, in which the ferrite core has an additional limb (35) and at least three outer limbs (37).

7. Measurement head (31) according to Claim 6, in which the at least three outer limbs (37) are arranged around the additional limb (35) in a point symmetrical fashion or rotationally symmetrical fashion.

8. Magnetoelastic sensor having a measurement head according to one of the preceding claims.

## Revendications

1. Tête (1, 21, 31) de mesure pour un capteur magnétoélastique, comprenant un noyau (3, 23, 33) de ferrite, qui a une forme en U ayant deux branches et qui comprend une première extrémité, sur laquelle est appliquée une bobine (9) d'excitation produisant un champ magnétique, et au moins une deuxième extrémité (7), dans laquelle un capteur (11, 41) de champ magnétique est mis sur la au moins une deuxième extrémité (7),
**caractérisée en ce que**
le capteur de champ magnétique repose sur l'effet Hall, l'effet GMR ou l'effet AMR.

2. Tête (1, 21, 31) de mesure suivant la revendication 1, dans laquelle le noyau (23, 33) de ferrite a une branche (25, 35) supplémentaire, la bobine (9) d'excitation étant montée sur la branche (25, 35) supplémentaire du noyau (23, 33) de ferrite et des capteurs (11, 41) de champ magnétique étant montés sur les branches (27, 37) extérieures du noyau (23, 33) de ferrite.

3. Tête (1, 21, 31) de mesure suivant la revendication 2, dans laquelle les branches (27, 37) extérieures entourent respectivement la même distance, la branche (25, 35) supplémentaire.

4. Tête (1, 21, 31) de mesure suivant la revendication 2 ou 3,
dans laquelle le noyau (23) de ferrite a une forme en E, en ayant une branche (25) supplémentaire et deux branches (27) extérieures.

5. Tête (1, 21, 31) de mesure suivant la revendication 4, dans laquelle les branches (27) extérieures sont disposées symétriquement comme en un miroir par rapport à la branche (25) supplémentaire.

6. Tête (1, 21, 31) de mesure suivant la revendication 2 ou 3,
dans laquelle le noyau de ferrite a une branche (35) supplémentaire et au moins trois branches (37) extérieures.

7. Tête (1, 21, 31) de mesure suivant la revendication 6, dans laquelle les au moins trois branches extérieures sont symétriques par rapport à un point ou symétriques en rotation autour de la branche (35) supplémentaire.

8. Capteur magnétoélastique ayant une tête de mesure suivant l'une des revendications précédentes.
